# DEMANDE DE BREVET EUROPEEN

(11) **EP 0 918 254 A2**
(43) Date de publication de la demande: **26.05.1999**
(21) Numéro de dépôt: 98402892.8
(22) Date de dépôt: 20.11.1998
(51) Int. Cl.: G03F 7/20, G03F 7/00

(54) **Procédé de formation de motifs dans une couche de résine photosensible, hologramme pour sa mise en oeuvre et application aux sources et écrans à micropointes**

(30) Priorité: 24.11.1997 FR 9714720
(71) Demandeur: COMMISSARIAT A L'ENERGIE ATOMIQUE, 75015 Paris Cédex 15 (FR)
(72) Inventeur: Ida, Michel, 38340 Voreppe (FR); Geffraye, Françoise, 38500 La Buisse (FR)
(74) Mandataire: Des Termes, Monique

(57) **Abrégé**

Procédé de formation de motifs dans une couche de résine photosensible, hologramme pour sa mise en oeuvre et système d'enregistrement de l'hologramme, application aux sources et écrans à micropointes.

Selon l'invention, on restitue l'image (140) d'un hologramme (138) d'une monocouche de microbilles éclairée par un faisceau de lumière dont les rayons sont parallèles et qui est perpendiculaire à la monocouche pour obtenir une image holographique tridimensionnelle de cette monocouche et de pinceaux de lumière associés à celle-ci et concentrés sous les images des microbilles, on restitue l'image tridimensionnelle (144) des pinceaux dans l'épaisseur de la couche de résine photosensible (22) pour provoquer l'insolation de zones de cette couche de résine, et on développe la couche de résine ainsi insolée.

## Description

### DOMAINE TECHNIQUE

La présente invention concerne un procédé de formation de motifs dans une couche de résine photosensible ("photoresist").

Ce procédé permet de former des trous dans cette couche si la résine photosensible est positive.

Si elle est négative, le procédé permet de former des plots en relief.

L'invention concerne aussi un hologramme permettant la mise en oeuvre de ce procédé ainsi qu'un système d'enregistrement de cet hologramme.

L'invention s'applique notamment à la fabrication de sources d'électrons à cathodes émissives à micropointes ("microtips") qui sont utilisées en particulier pour la fabrication de dispositifs de visualisation par cathodoluminescence excitée par émission de champ.

L'invention permet par exemple de fabriquer des écrans plats à micropointes de grande taille, par exemple supérieure à 14 pouces (environ 35 cm), et même des écrans plats à micropointes dont la superficie est voisine de 1 m².

Bien entendu des écrans de taille différente peuvent être élaborés grâce à la présente invention.

### ÉTAT DE LA TECHNIQUE ANTÉRIEURE

Des sources d'électrons à cathodes émissives à micropointes et leurs procédés de fabrication sont décrits par exemple dans les documents (1) à (4) auxquels on se reportera et qui, comme les autres documents cités par la suite, sont mentionnés à la fin de la présente description.

Pour faciliter la compréhension du problème technique résolu par la présente invention, on décrit ci-après un exemple connu de procédé de fabrication d'une source d'électrons à cathodes émissives à micropointes.

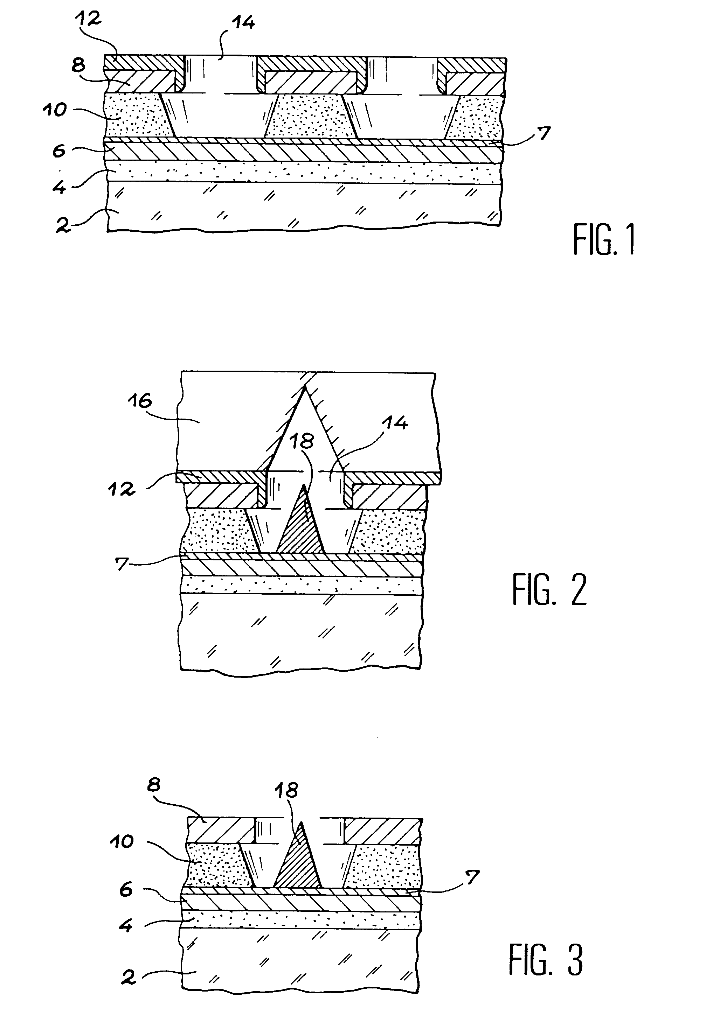

On se référera aux figures 1 à 3 des dessins annexés.

La figure 1 montre une structure déjà élaborée, comprenant, sur un substrat 2 surmonté d'un isolant 4, un système composé de conducteurs cathodiques 6, d'une couche résistive 7 et de grilles 8, les conducteurs 6 et les grilles 8 étant superposés sous forme croisée, avec un isolant intermédiaire 10, et une couche 12, par exemple en nickel, déposée en surface pour servir de masque lors des opérations de réalisation des micropointes.

Cette couche 12 de nickel, les grilles 8 et l'isolant 10 sont percés de trous 14, au fond desquels il s'agit de déposer ultérieurement les micropointes constituées d'un métal conducteur en liaison électrique avec les conducteurs cathodiques 6 à travers la couche résistive 7.

La réalisation des micropointes va maintenant être expliquée en faisant référence à la figure 2.

On commence d'abord par effectuer par exemple le dépôt d'une couche en molybdène 16 sur l'ensemble de la structure.

Cette couche 16 présente une épaisseur d'environ 1,8 µm.

Elle est déposée sous incidence normale par rapport à la surface de la structure.

Cette technique de dépôt permet d'obtenir des cônes 18 en molybdène logés dans les trous 14 et ayant une hauteur de 1,2 à 1,5 µm.

Ces cônes constituent les micropointes émettrices d'électrons.

On réalise ensuite la dissolution sélective de la couche de nickel 12 par un procédé électrochimique, de façon à dégager, comme on le voit sur la figure 3, les grilles perforées 8, par exemple en niobium, et à faire apparaître les micropointes 18 émettrices d'électrons.

A quelques variantes technologiques près, la méthode connue ainsi décrite en se référant aux figures 1, 2 et 3 est l'une de celles qui sont utilisées pour réaliser les micropointes des sources d'électrons à cathodes émissives à micropointes.

Pour que la taille et le positionnement des micropointes 18 soient corrects il faut, bien entendu, maîtriser parfaitement la taille des trous réalisés dans les grilles 8 et dans l'isolant 10.

Le problème est le suivant :

Il s'agit de réaliser, sur toutes les surfaces devant recevoir des micropointes, des trous dont le diamètre moyen est par exemple de 1,3 µm ou moins.

Les méthodes actuellement utilisées pour réaliser ces trous font appel à des procédés de photolithogravure utilisant la projection directe ou la photorépétition d'un motif élémentaire reproduit sur toutes ces surfaces.

Dans le cas de sources d'électrons de grande taille, supérieure à 14 pouces (environ 35 cm) par exemple, ces procédés deviennent vite très contraignants.

La projection directe nécessite la réalisation d'un masque à l'échelle 1 de grande taille, comportant des motifs submicroniques.

Ces motifs sont en général composés de métal en couche mince déposé sur un substrat de silice ou de verre.

Ce masque est difficilement réalisable au dessus de 14 pouces de diagonale avec les techniques classiques utilisées en micro-électronique.

En ce qui concerne la photorépétition, on utilise un masque de petite taille, cette taille étant déterminée par la résolution des motifs utilisés.

Pour une résolution de 1 µm, on utilise par exemple un masque de 20 à 50 mm de côté, ce qui oblige à répéter un grand nombre de fois l'opération d'insolation qui est nécessaire à la photolithogravure, pour couvrir la surface totale de la source d'électrons.

Ces deux méthodes (l'une utilisant la projection directe et l'autre la photorépétition) sont donc difficilement applicables à la réalisation de sources d'électrons de grande taille.

Selon une autre méthode connue par les documents (5), (6) et (7), auxquels on se reportera, pour former des trous dans une couche de résine photosensible positive, au moyen d'une lumière d'insolation,
- on forme une monocouche de microbilles transparentes à cette lumière d'insolation et en contact direct avec la couche de résine,
- on insole cette couche de résine par la lumière d'insolation, à travers la monocouche de microbilles, chaque microbille concentrant cette lumière au point de contact de cette microbille avec la couche de résine sur laquelle elle est posée et provoquant ainsi l'insolation d'une zone de cette couche de résine, la lumière d'insolation formant un faisceau parallèle, collimaté et d'intensité lumineuse constante sur toute la monocouche de microbilles, et
- on développe la couche de résine ainsi insolée, d'où la formation des trous dans cette couche, à la place des zones insolées.

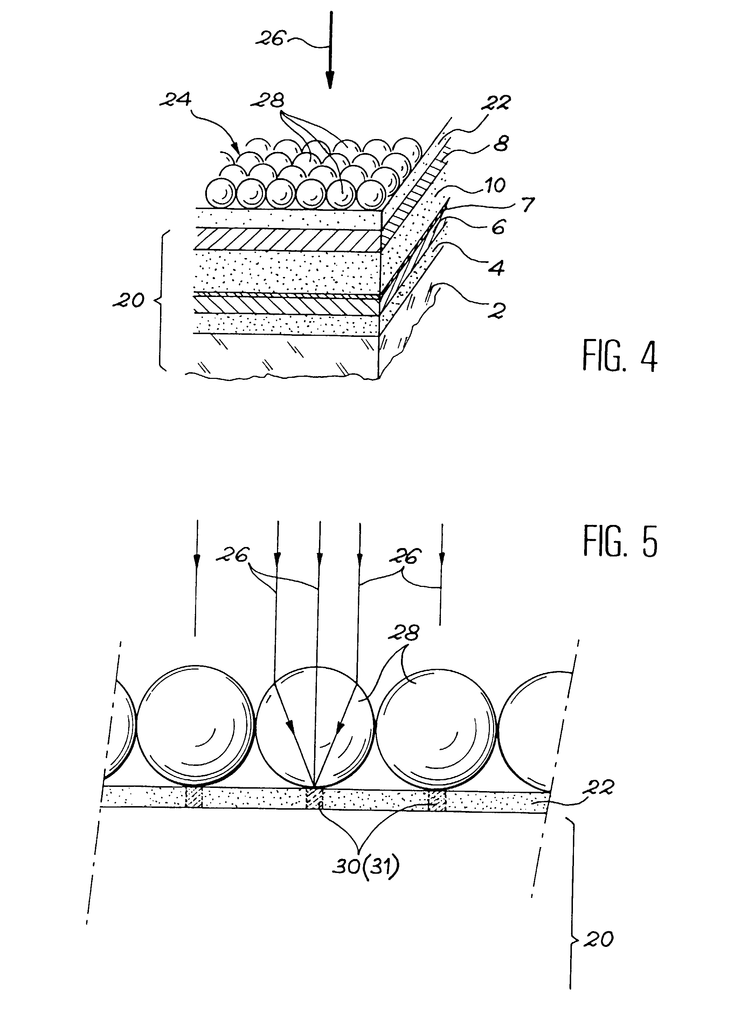

Les figures 4 à 6 illustrent cette autre méthode connue.

La figure 4 montre de façon schématique et partielle la structure dont il a été question dans la description des figures 1 à 3 et qui comprend le substrat 2, l'isolant 4, les conducteurs cathodiques 6, la couche résistive 7, les grilles 8 en l'isolant intermédiaire 10.

On se propose de faire des trous dans les grilles 8 et l'isolant intermédiaire 10.

Pour faire ces trous, on dépose sur la surface de la structure, qui porte la référence 20 sur la figure 4, une couche 22 de résine photosensible positive.

On dépose ensuite, sur la surface de cette couche de résine 22, une monocouche 24 de microbilles qui sont transparentes à la lumière 26 utilisée pour insoler la résine.

On insole cette couche de résine par cette lumière 26, à travers la couche de microbilles 24 et perpendiculairement à la couche de résine 22.

Cette lumière 26 forme un faisceau lumineux parallèle, collimaté et d'intensité lumineuse constante sur toute la surface de la monocouche de microbilles, ce faisceau provenant d'une source lumineuse non représentée.

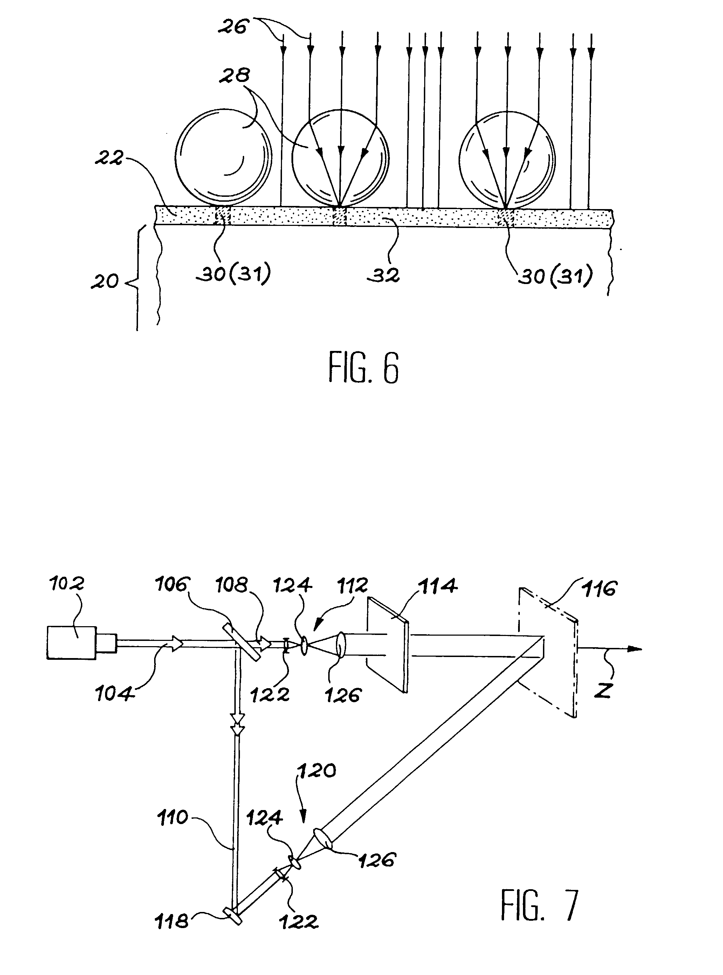

Comme on le voit sur la figure 5, chacune des microbilles 28 est prévue pour concentrer cette lumière au point de contact de cette microbille avec la couche de résine 22 et provoque ainsi l'insolation d'une zone 30 de cette couche de résine qui se trouve sous chaque microbille. (Il convient de noter que la figure 5 est un schéma de principe comme d'ailleurs la figure 6 : chaque microbille étant sphérique, il se produit des aberrations sphériques de sorte que la zone de concentration de lumière correspond sensiblement à la zone 30 et que l'on insole toute cette zone 30 dans l'épaisseur de la couche de résine 22).

On enlève ensuite les microbilles de la surface de la structure 20 et on développe la couche de résine ainsi insolée (en d'autres termes, on dissout les zones de résine insolées), d'où la formation de trous 31 dans cette couche de résine, à la place des zones insolées 30.

Dans le cas des figures 4 et 5, les microbilles déposées à la surface de la structure 20 sont jointives.

La figure 6 illustre schématiquement la possibilité de déposer à la surface de la couche de résine 22 une monocouche de microbilles qui ne sont pas jointives et dont la répartition peut être aléatoire.

La méthode connue, schématiquement illustrée par les figures 4 à 6, présente des inconvénients :
- elle est compliquée et
- elle nécessite une grande quantité de microbilles pour sa mise en oeuvre.

On connaît en outre un système holographique permettant l'insolation d'une couche de résine photosensible.

Ce système, fabriqué par la Société Holtronic, utilise un hologramme qui est par exemple déposé sur une plaque de quartz et formé à partir d'un masque bidimensionnel classiquement utilisé en microélectronique.

Ce système connu nécessite un ajustement très précis de la position de l'image holographique sur la couche de résine photosensible, perpendiculairement à celle-ci, pour conserver une résolution micronique ou submicronique.

### EXPOSÉ DE L'INVENTION

La présente invention a pour but de remédier aux inconvénients des techniques connues, mentionnées plus haut.

Elle a pour objet un procédé de formation de trous dans une couche de résine photosensible, ce procédé étant caractérisé en ce qu'il comprend les étapes suivantes :
- on restitue l'image d'un hologramme d'une monocouche de microbilles éclairée par une faisceau de lumière dont les rayons sont parallèles et qui est perpendiculaire à la monocouche pour obtenir une image holographique tridimensionnelle de cette monocouche et de pinceaux de lumière associés à celle-ci et concentrés sous les images des microbilles,
- on restitue l'image tridimensionnelle des pinceaux de lumière dans l'épaisseur de la couche de résine photosensible pour provoquer l'insolation de zones de cette couche de résine, et
- on développe la couche de résine ainsi insolée, des motifs étant alors formés au niveau des zones insolées.

Le procédé objet de l'invention est simple à mettre en oeuvre et permet de traiter des substrats de grande taille, recouverts d'une couche de résine photosensible.

L'invention permet de former (avec un hologramme de microbilles suffisamment petites) des trous dont le diamètre peut être de l'ordre de 1 µm ou inférieur à 1 µm, sur de petites surfaces ou sur de grandes surfaces. D'autres dimensions supérieures peuvent être obtenues avec des microbilles plus grosses.

La résine photosensible, une fois développée, peut servir de masque pour former des motifs dans une structure sur laquelle se trouve cette couche.

Par exemple, en considérant la structure décrite en faisant référence aux figures 1 à 3, une couche de résine photosensible positive peut servir, après développement, à graver les grilles 8 et l'isolant intermédiaire 10.

Selon un premier mode de mise en oeuvre particulier du procédé objet de l'invention, l'hologramme est un hologramme dans l'axe.

Selon un deuxième mode de mise en oeuvre particulier, l'hologramme est un hologramme hors axe.

Les microbilles peuvent être jointives et leurs images holographiques le sont alors aussi.

Au contraire, les microbilles peuvent ne pas être jointives et leurs images holographiques ne le sont alors pas non plus.

Dans ce dernier cas, la répartition des microbilles non jointives peut être aléatoire (ce qui conduit à une répartition aléatoire des images holographiques des microbilles).

De préférence, les microbilles ont un diamètre de l'ordre de 1 µm à 10 µm.

D'une façon générale, l'invention permet d'obtenir des motifs ayant une forme prédéfinie en adaptant l'image holographique des pinceaux de lumière en conséquence et en choisissant donc des microbilles et la disposition de celles-ci de manière à obtenir de tels pinceaux de lumière.

On peut utiliser une résine photosensible positive, les motifs formés étant alors des trous.

Au contraire, on peut utiliser une résine photosensible négative, les motifs formés étant alors des plots.

Dans ce dernier cas, l'invention s'applique par exemple à la fabrication d'optiques diffractives binaires.

L'invention a également pour objet un hologramme d'une monocouche de microbilles éclairée par un faisceau de lumière dont les rayons sont parallèles et qui est perpendiculaire à la monocouche, cet hologramme étant apte à fournir une image holographique tridimensionnelle de cette monocouche et de pinceaux de lumière associés à celle-ci et concentrés sous les images des microbilles.

Cet hologramme peut être un hologramme dans l'axe ou un hologramme hors axe.

La taille de l'image holographique de chacun des pinceaux de lumière est de préférence de l'ordre de 1 µm à 10 µm.

Ceci résulte de l'utilisation de microbilles dont le diamètre a cet ordre de grandeur et de tels pinceaux permettent d'obtenir des motifs micrométriques (trous ou plots suivant la résine photosensible utilisée).

L'invention concerne aussi un système d'enregistrement de l'hologramme objet de l'invention, ce système comprenant un montage holographique de Leith-Upatnieks par transmission ou de Gabor.

La présente invention concerne aussi un procédé de fabrication d'une source d'électrons à cathodes émissives à micropointes, procédé selon lequel :
- on forme une structure comprenant des conducteurs cathodiques sur un substrat, une couche électriquement isolante, des grilles qui font un angle avec les conducteurs cathodiques,
- dans les domaines où les grilles croisent les conducteurs cathodiques, on force des trous à travers les grilles et la couche isolante, et
- on forme des micropointes en matériau émetteur d'électrons dans ces trous, sur les conducteurs cathodiques,
ce procédé étant caractérisé en ce que ces trous sont obtenus en formant une couche de résine photosensible positive au moins dans lesdits domaines, à la surface de la structure, en formant des trous dans la couche de résine conformément au procédé de formation de motifs objet de l'invention, et en gravant les grilles et la couche isolante à travers ces trous formés dans la couche de résine.

L'invention concerne aussi un écran plat utilisant la source d'électrons ainsi fabriquée.

L'invention permet de simplifier notablement la technique connue par les documents (5) à (7).

En effet, cette technique nécessite la formation d'une monocouche de microbilles chaque fois que l'on veut faire des trous dans une couche de résine photosensible.

Au contraire, avec l'invention, il suffit de former une fois pour toutes l'hologramme de la monocouche de microbilles (et des pinceaux de lumière associés) et de réutiliser cet hologramme chaque fois que l'on veut former des motifs, par exemple des trous, dans une couche de résine photosensible.

On dispose ainsi d'un procédé plus simple pour la formation de motifs dans une telle couche et l'on réduit notablement la consommation de microbilles.

De plus, l'invention utilise l'hologramme des pinceaux de lumière qui sont associés à la monocouche de microbilles et perpendiculaires à celle-ci.

La longueur de ces pinceaux de lumière (qui dépend du diamètre des microbilles, de la nature de celles-ci et des conditions d'éclairement) peut être de l'ordre de quelques micromètres pour des microbilles ayant un diamètre de quelques micromètres.

Or il en est de même pour les images holographiques de ces pinceaux de lumière, images qui ont la même fonction optique que les pinceaux de lumière.

La longueur de ces images permet d'avoir, vis-à-vis du système mentionné plus haut de la société Holtronic, une plus grande latitude pour l'ajustement de la position de l'hologramme suivant une direction perpendiculaire à la couche de résine photosensible.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1 à 3, déjà décrites, illustrent de façon schématique et partielle un procédé connu de fabrication d'une source d'électrons à cathodes émissives à micropointes,
- les figures 4 à 6, déjà décrites, illustrent de façon schématique et partielle un procédé connu de photolithographie par l'intermédiaire d'une monocouche de microbilles déposées sur une couche de résine photosensible,
- la figure 7 illustre schématiquement un système connu, permettant l'enregistrement d'un hologramme hors axe encore appelé hologramme de Leith-Upatnieks utilisable dans l'invention,
- la figure 8 illustre schématiquement l'enregistrement d'un hologramme hors axe d'une monocouche de microbilles au moyen du système représenté sur la figure 7,
- la figure 9 illustre schématiquement la restitution de cet hologramme hors axe de la monocouche de microbilles, pour former des motifs dans une couche de résine photosensible conformément à l'invention,
- la figure 10 illustre schématiquement un autre système connu, permettant l'enregistrement d'un hologramme dans l'axe, encore appelé hologramme de Gabor, utilisable dans l'invention,
- la figure 11 illustre schématiquement l'enregistrement d'un hologramme dans l'axe d'une monocouche de microbilles au moyen du système représenté sur la figure 10, et
- la figure 12 illustre schématiquement la restitution de cet hologramme dans l'axe de la monocouche de microbilles, pour former des motifs dans une couche de résine photosensible conformément à l'invention.

### EXPOSÉ DÉTAILLÉ DE MODES DE RÉALISATION PARTICULIERS

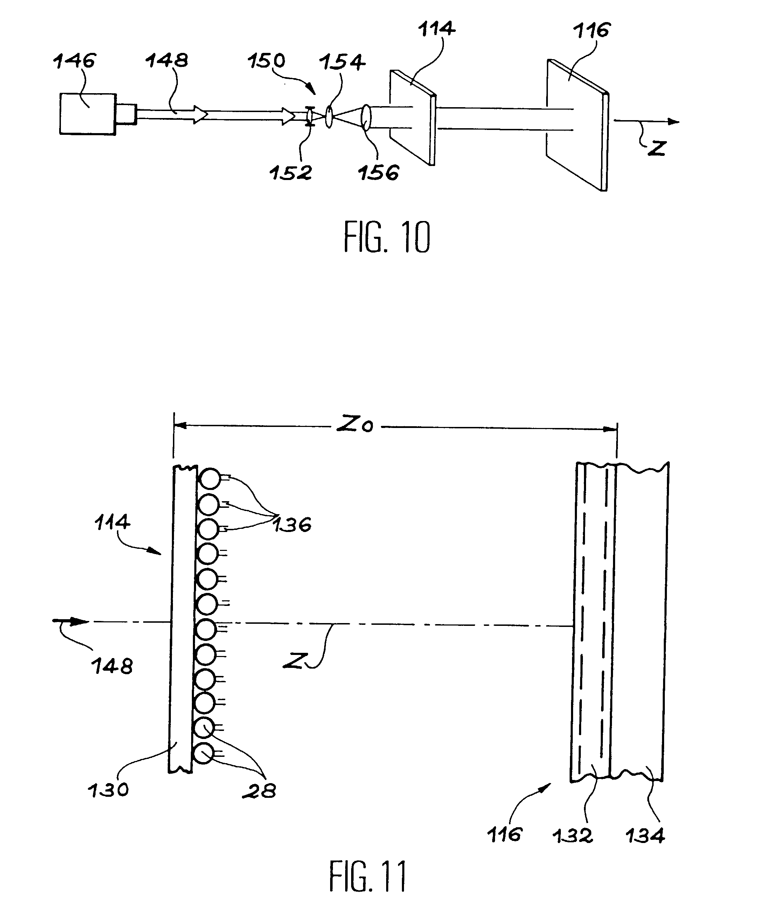

Deux systèmes d'enregistrement d'un hologramme, schématiquement représentés sur les figures 7 et 10, sont utilisables dans la présente invention.

Le système permettant la restitution de l'hologramme et l'exposition ou Insolation de la résine photosensible à travers cet hologramme dépend du choix du système d'enregistrement de l'hologramme.

Considérons d'abord le système d'enregistrement d'un hologramme hors axe (appelé hologramme de Leith-Upatnieks) qui est schématiquement représenté sur la figure 7.

Il s'agit en fait d'un montage holographique hors axe par transmission.

Le système représenté sur la figure 7 comprend un laser 102 qui fournit un faisceau lumineux 104 servant à l'enregistrement de l'hologramme hors axe.

Le système comprend aussi une lame séparatrice 106 qui fournit, à partir du faisceau 104, un faisceau lumineux 108, appelé faisceau objet, et un faisceau lumineux de référence 110.

Le faisceau lumineux 108 traverse un système de collimation 112 puis atteint l'objet 114 dont on veut former un hologramme.

Cet objet 114 diffuse le faisceau 108 et le faisceau lumineux diffusé atteint la plaque holographique 116.

Le faisceau de référence 110 se réfléchit d'abord sur un miroir 118 puis traverse un autre système de collimation 120 pour parvenir à la plaque holographique 116 en laquelle ce faisceau de référence 110 interfère avec le faisceau résultant de la diffusion du faisceau objet 108.

Chacun des systèmes de collimation 112 et 120 est successivement constitué d'un objectif de microscope 122 d'un trou spatial 124 et d'un objectif 126.

Le faisceau 104 est un faisceau à rayons parallèles et il en est donc de même pour les faisceaux 108 et 110.

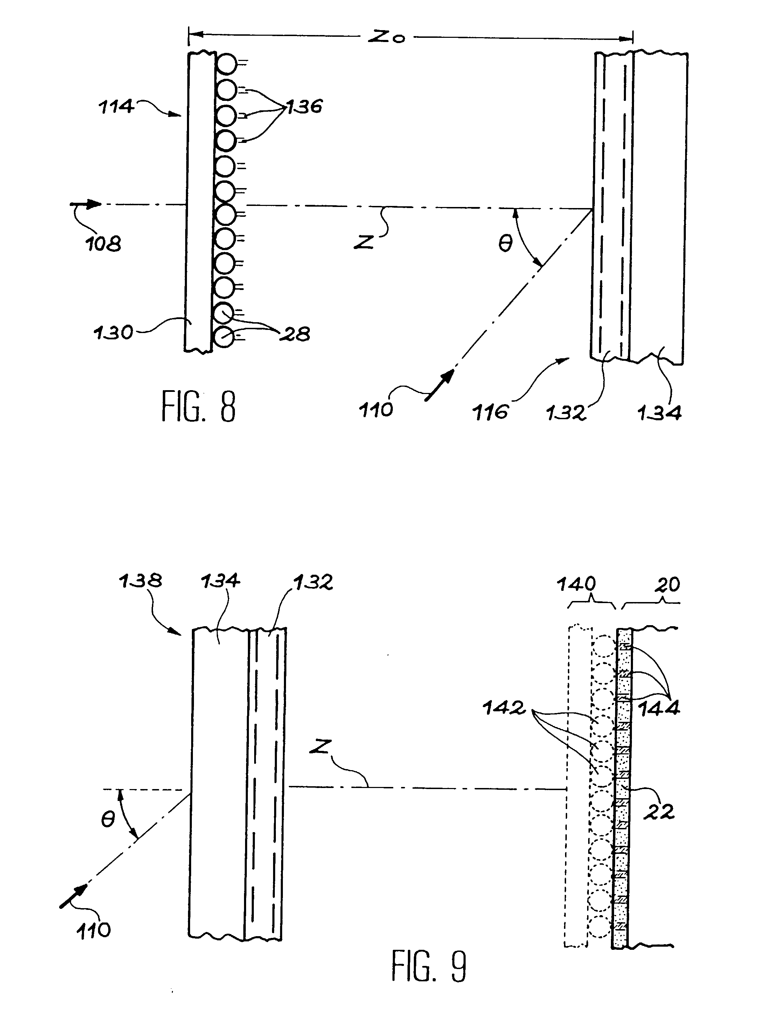

Pour la mise en oeuvre de l'invention l'objet 114 est une monocouche (plane) de microbilles 28 comme on le voit sur la figure 8.

Ces microbilles sont transparentes à la lumière du laser 102 et maintenues sur une plaque de verre 130 qui est également transparente à la lumière du laser 102.

La manière d'obtenir une telle monocouche de microbilles (jointives ou non) est expliquée dans les documents (5) à (7) auxquels on se reportera.

Comme on le voit sur la figure 8, la plaque holographique comprend une couche de gélatine appropriée 132 sur une plaque de verre 134.

La monocouche de microbilles 28 est parallèle à la couche de gélatine 132.

On voit sur les figures 7 et 8 un axe Z suivant lequel se propagent le faisceau laser 104 et le faisceau objet 108 et qui est perpendiculaire au plan de la monocouche 28 et au plan de la couche 132.

Le laser 102 utilisé pour l'enregistrement de l'hologramme est par exemple un laser argon.

Celui-ci fournit une onde monochromatique plane (faisceau lumineux 104) de sorte que les faisceaux lumineux 108 et 110 sont aussi des ondes monochromatiques planes, les plans d'onde du faisceau 108 étant perpendiculaires à l'axe Z.

La distance Zo entre l'objet 114 et la plaque holographique 116 (ou plus précisément la distance de la face de la plaque de verre 130 opposée à celle sur laquelle repose la monocouche de microbilles 28 et la face de la plaque de verre 134 sur laquelle repose la couche de gélatine 132) dépend des dimensions de la plaque holographique 116 et de la résolution choisie ainsi que de l'angle θ que fait le faisceau objet 108 avec le faisceau de référence 110.

Conformément à l'invention on enregistre dans la couche de gélatine 132 non seulement l'image de la monocouche de microbilles 28 et de la plaque 130 mais encore l'image des pinceaux lumineux 136 qui sont formés par interaction du faisceau objet 108 avec les microbilles et sont concentrés sous ces microbilles.

Après avoir enregistré l'hologramme on développe celui-ci et l'on utilise cet hologramme pour insoler une couche de résine photosensible telle que la couche 22 des figures 4 à 6.

La restitution de cet hologramme est schématiquement illustrée par la figure 9.

Pour cette restitution seul est utilisé le faisceau de référence original 110 (onde plane) qui fait encore un angle θ avec l'axe Z perpendiculaire à l'hologramme développé 138, le faisceau 110 étant envoyé sur la couche de gélatine développée 132 à travers la plaque 134.

Ce faisceau de référence 110 sert également à l'insolation de la couche de résine photosensible 22.

Plus précisément pour la restitution de l'hologramme et l'insolation de la couche 22 on utilise un système d'insolation du même type que celui qui est utilisé par la société Holtronic mentionnée plus haut.

Ce type de restitution permet de s'affranchir de la réflexion spéculaire du faisceau laser principal 104.

Lors de cette restitution on obtient une image holographique tridimensionnelle réelle 140 des microbilles 28, de la plaque 130 et des pinceaux de lumière 136 associés aux microbilles.

L'image tridimensionnelle des pinceaux de lumière permet d'insoler la couche de résine 22 pour y former des trous (la résine photosensible étant positive dans l'exemple considéré).

Pour insoler la couche de résine photosensible on fait en sorte que l'image holographique 142 de la monocouche de microbilles soit sensiblement tangente à la surface libre de la couche de résine photosensible 22.

Ainsi l'image holographique 144 des pinceaux de lumière se trouve dans cette couche de résine photosensible et insole celle-ci.

Le temps d'insolation est bien entendu ajusté pour que les zones de la couche 22 correspondant aux trous soient insolées avec une dose de lumière supérieure au seuil de développement de la résine photosensible et pour que le reste de la couche 22 soit insolé avec une dose inférieure à ce seuil.

Après insolation la résine photosensible est développée de façon classique.

Pour former une source à cathodes émissives à micropointes, on utilise la structure 20 mentionnée plus haut et l'on étale une couche de résine photosensible positive 22 sur toute la surface de celle-ci.

L'épaisseur de la couche photosensible 22 vaut par exemple 1 µm.

On durcit ensuite cette couche de résine par étuvage.

On insole la couche de résine photosensible au moyen de l'hologramme puis on développe cette couche de manière classique.

Après développement et obtention des trous dans la couche de résine photosensible, cette couche ainsi microperforée sert elle-même de masque pour la formation de trous dans les couches sous-jacentes 8 et 10 de la structure 20 pour l'obtention d'une structure conforme à la figure 1 déjà décrite.

Plus précisément on grave à travers les trous formés dans la couche de résine photosensible les grilles 8 et l'isolant intermédiaire 10 pour y former les trous 14 (figure 1).

On enlève ensuite la couche de résine photosensible 22.

Ensuite, on dépose sous incidence rasante la couche de nickel 12 sur la structure obtenue.

On dépose ensuite la couche de molybdène 16, d'où la formation des micropointes 18, et l'on enlève la couche de nickel 12 et par là même le molybdène 16 qui se trouve au-dessus de cette couche de nickel 12.

Dans un autre mode de mise en oeuvre particulier du procédé objet de l'invention, on dispose une couche de résine photosensible négative sur un substrat approprié.

L'insolation de cette couche de résine photosensible négative à travers l'hologramme puis le développement de cette couche ainsi insolée conduisent à un ensemble de plots de résine photosensible négative sur le substrat.

Comme cela est indiqué dans les documents (5) à (7) on peut utiliser à titre d'exemple des microbilles en silice ayant un diamètre de 4 µm.

Selon les motifs que l'on veut obtenir dans la couche de résine photosensible on peut utiliser des microbilles jointives ou non jointives pour enregistrer l'hologramme.

La figure 10 illustre schématiquement un montage holographique dans l'axe, ou montage holographique de Gabor, permettant encore d'enregistrer un hologramme pour la mise en oeuvre de l'invention.

Ce montage comprend un laser 146 qui fournit un faisceau lumineux monochromatique 148 à rayons parallèles (onde plane).

Ce faisceau principal traverse un système de collimation 150 comprenant successivement un objectif de microscope 152, un trou spatial 154 et un objectif 156.

Ce faisceau atteint ensuite un objet qui est identique à l'objet 114 des figures 7 et 8 puis la partie transmise de ce faisceau 148 atteint la plaque holographique sur laquelle on veut enregistrer l'hologramme et qui est identique à la plaque holographique 116 des figures 7 et 8.

L'interaction du faisceau transmis avec l'objet 114 engendre un faisceau lumineux diffusé qui atteint la plaque 116 ou il interfère avec le faisceau 48.

L'enregistrement de l'hologramme est plus précisément illustré par la figure 11.

Une seule onde-objet est alors nécessaire pour l'enregistrement et aussi pour la restitution d'un tel hologramme (hologramme de Gabor).

L'avantage principal de ce type d'hologramme par rapport à l'hologramme des figures 7 et 8 réside dans le fait que le montage optique est simplifié et qu'il nécessite un film ou plaque holographique dont la résolution est moins grande que la résolution du film utilisé pour l'enregistrement d'un hologramme de Leith-Upatnieks.

Lorsque l'hologramme est enregistré on le développe et on peut alors l'utiliser pour former des motifs dans une couche de résine photosensible.

Pour ce faire on restitue l'hologramme.

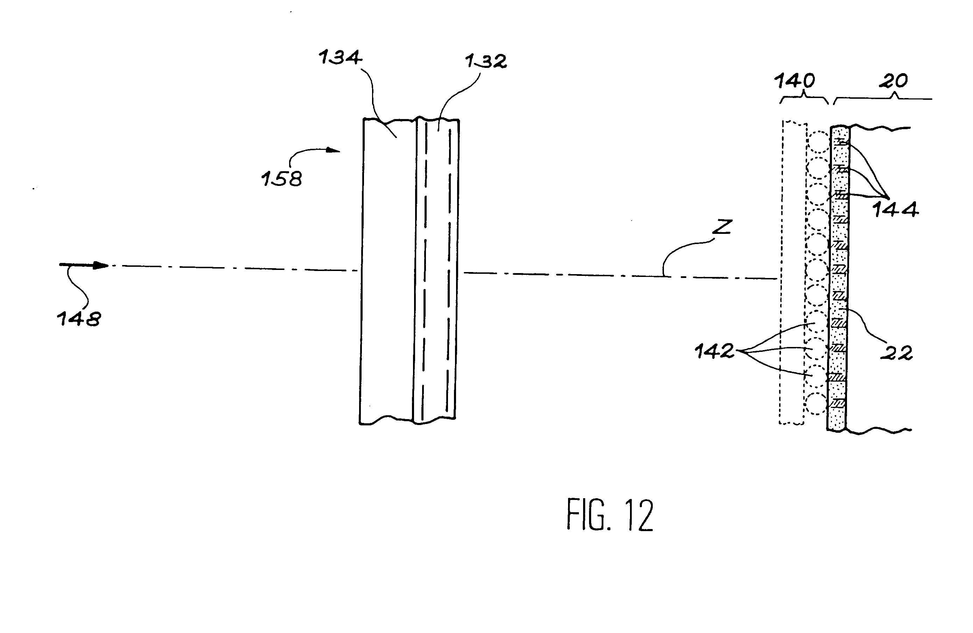

Ceci est schématiquement illustré par la figure 12.

Pour cette restitution on utilise un système d'insolation du genre des insolateurs de proximité qui sont développés par la société Karl Suss.

Dans ce cas le système est beaucoup plus simple que celui qui est utilisé pour former un hologramme hors axe.

Pour la restitution et l'insolation on utilise le faisceau 148 et l'on envoie ce faisceau sur l'hologramme développé 158 perpendiculairement à celui-ci et à travers la plaque 134.

On fait encore en sorte que l'image holographique des microbilles soit sensiblement tangente à la face libre de la couche de résine photosensible 22.

Ainsi les images holographiques 144 des pinceaux de lumière 136 se trouvent encore dans cette couche 22 pour insoler celle-ci.

Après restitution optique de l'hologramme dans l'axe et insolation de la couche de résine photosensible à travers cet hologramme on développe cette couche.

On utilise ensuite cette couche de résine photosensible comme on l'a expliqué plus haut si l'on veut par exemple fabriquer une source d'électrons à micropointes en utilisant dans ce cas une résine photosensible positive.

Les documents cités dans la présente description sont les suivants :
(1) FR-A-2 593 953 (voir aussi EP-A-0 234 989)
(2) US-A-4 857 161 (correspondant au document (1))
(3) FR-A-2 663 462 (voir aussi EP-A-0 461 990 et US-A-5 194 780)
(4) FR-A-2 687 839 (voir aussi EP-A-0 558 393 et la demande de brevet américain du 26 février 1993, numéro de série 08/022,935 de Leroux et al.)
(5) FR-A-2725558 (demande de brevet français n°9412065 du 10 octobre 1994)
(6) EP-A-0707237 (correspondant au document (5))
(7) Demande de brevet américain, numéro de série 08/533,719, du 26 Septembre 1995 (correspondant aussi au document (5)) .

## Revendications

1. Procédé de formation de motifs dans une couche de résine photosensible (22), ce procédé étant caractérisé en ce qu'il comprend les étapes suivantes :
- on restitue l'image d'un hologramme (138, 158) d'une monocouche de microbilles (28) éclairée par un faisceau de lumière dont les rayons sont parallèles et qui est perpendiculaire à la monocouche pour obtenir une image holographique tridimensionnelle (140) de cette monocouche et de pinceaux de lumière (136) associés à celle-ci et concentrés sous les images des microbilles,
- on restitue l'image tridimensionnelle (144) des pinceaux de lumière dans l'épaisseur de la couche de résine photosensible pour provoquer l'insolation de zones de cette couche de résine, et
- on développe la couche de résine ainsi insolée, des motifs étant alors formés au niveau des zones insolées.

2. Procédé selon la revendication 1, dans lequel l'hologramme est un hologramme dans l'axe (158).

3. Procédé selon la revendication 1, dans lequel l'hologramme est un hologramme hors axe (138).

4. Procédé selon l'une quelconque des revendications 1 à 3, dans lequel les microbilles (28) sont jointives, leurs images holographiques l'étant donc aussi.

5. Procédé selon l'une quelconque des revendications 1 à 3, dans lequel les microbilles (28) ne sont pas jointives, leurs images holographiques ne l'étant donc pas non plus.

6. Procédé selon la revendication 5, dans lequel la répartition des microbilles non jointives est aléatoire.

7. Procédé selon l'une quelconque des revendications 1 à 6, dans lequel les microbilles (28) ont un diamètre de l'ordre de 1 µm à 10 µm.

8. Procédé selon l'une quelconque des revendications 1 à 7, dans lequel la résine photosensible est positive de sorte que les motifs formés sont des trous.

9. Procédé selon l'une quelconque des revendications 1 à 7, dans lequel la résine photosensible est négative de sorte que les motifs formés sont des plots.

10. Hologramme d'une monocouche de microbilles (28) éclairée par un faisceau de lumière dont les rayons sont parallèles et qui est perpendiculaire à la monocouche, cet hologramme étant apte à fournir une image holographique tridimensionnelle (140) de cette monocouche et de pinceaux de lumière (136) associés à celle-ci et concentrés sous les images des microbilles.

11. Hologramme selon la revendication 10, cet hologramme étant un hologramme dans l'axe (158) ou un hologramme hors axe (138).

12. Hologramme selon l'une quelconque des revendications 10 et 11, la taille de l'image holographique (144) de chaque pinceau de lumière étant de l'ordre de 1 µm à 10 µm.

13. Système d'enregistrement de l'hologramme selon la revendication 10, ce système comprenant un montage holographique de Leith-Upatnieks par transmission (102, 106, 112, 118, 120) ou de Gabor (146, 150).

14. Procédé de fabrication d'une source d'électrons à cathodes émissives à micropointes, procédé selon lequel :
- on forme une structure comprenant des conducteurs cathodiques (6) sur un substrat (2), une couche électriquement isolante (10) sur ces conducteurs cathodiques, et, sur cette couche électriquement isolante, des grilles (8) qui font un angle avec les conducteurs cathodiques,
- dans les domaines où les grilles croisent les conducteurs cathodiques, on forme des trous (14) à travers les grilles et la couche isolante, et
- on forme des micropointes (18) en matériau émetteur d'électrons dans ces trous, sur les conducteurs cathodiques,
ce procédé étant caractérisé en ce que ces trous sont obtenus en formant une couche de résine photosensible positive (22) au moins dans lesdits domaines, à la surface de la structure, en formant des trous dans la couche de résine conformément au procédé selon l'une quelconque des revendications 1 à 8, et en gravant les grilles et la couche isolante à travers ces trous formés dans la couche de résine.

15. Ecran plat utilisant la source d'électrons obtenue par le procédé selon la revendication 14.
